# EUROPÄISCHE PATENTSCHRIFT

(11) **EP 0 292 827 B1**
(45) Veröffentlichungstag und Bekanntmachung des Hinweises auf die Patenterteilung: **03.03.1993**
(21) Anmeldenummer: 88107811.7
(22) Anmeldetag: 16.05.1988
(51) Int. Cl.: G08B 13/24, H01L 27/01

(54) **Verfahren zur Herstellung von Etiketten mit jeweils einer einen Schwingkreis bildenden Schaltung**
Method of making tags with respectively a circuit forming a resonant circuit
Procédé pour la fabrication d'étiquettes avec respectivement un circuit formant un circuit oscillant

(30) Priorität: 22.05.1987 CH 2003/87
(43) Veröffentlichungstag der Anmeldung: 30.11.1988
(73) Patentinhaber: Actron Entwicklungs AG, CH-6343 Rotkreuz (CH)
(72) Erfinder: Richter-Jörgensen, Poul, Almunecar (ES)
(74) Vertreter: Lauer, Joachim, Dr.

(56) Entgegenhaltungen:
- EP-A- 0 142 380
- EP-A- 0 209 816
- WO-A-83/04448

## Beschreibung

Die vorliegende Erfindung betrifft ein Verfahren zur Herstellung einer Vielzahl von auf einem Streifen hintereinander angeordneten Etiketten, von denen jede jeweils eine einen Schwingkreis bildende Schaltung aus einem induktiven und wenigstens einem kapazitiven Element trägt und einen isolierenden Träger umfasst, auf dessen einer Seite das aus flachen elektrischen Leiterbahnen gebildete induktive Element und mit letzterem verbunden die eine Fläche des kapazitiven Elements mustergemäss angeordnet sind, während sich auf der Rückseite des isolierenden Trägers die Gegenfläche des kapazitiven Elementes, mit dem Schaltkreis auf der Vorderseite elektrisch verbunden, befindet, ferner Etiketten mit jeweils einer einen Schwingkreis bildenden Schaltung hergestellt nach diesem Verfahren und die Verwendung solcher Etiketten in Warensicherungssystemen.

Die vorliegende Erfindung betrifft somit insbesondere ein neuartiges Verfahren für die Herstellung von elektrische Schwingkreise tragenden Etiketten, wie solche immer häufiger für besondere Anwendungen in den verschiedensten Industriezweigen eingesetzt werden. Solche Schwingkreise tragenden Etiketten dienen unter anderem zur Beobachtung und Erkennung von sich bewegenden Objekten, wobei die gegebenenfalls abgegebenen Signale zur Einleitung weiterer Verfahrensabläufe dienen. Eine besondere Verwendung finden die Etiketten in sogenannten Warensicherungssystemen.

Entscheidend für solche Anwendungen ist, dass die Schwingkreise einerseits preisgünstig und andererseits, und dies vor allem, eine hohe Frequenzgenauigkeit und Spulenqualität aufweisen, damit Fehldetektionen mit hoher Wahrscheinlichkeit vermieden werden können.

Derartige Schwingkreise tragende Etiketten sind heute bereits stark verbreitet. Sie werden nach verschiedensten Verfahren hergestellt (vg. zB. WO-A-8 304 448 und EP-A-0 142 380), wobei üblicherweise als Ausgangsmaterial ein Träger aus einem elektrisch nichtleitenden Material verwendet wird, auf dessen Vorder- und Rückseite jeweils eine leitende Folie vorgesehen sind. Aus diesen Folien werden dann die gewünschten Leiterbahnen zur Bildung der induktiven und kapazitiven Elemente herausgearbeitet. Dies erfolgt üblicherweise mittels besonderer Aetzverfahren, wobei jedoch auch bereits andere Verfahren, wie beispielsweise Stanzen oder der Einsatz von Lasern vorgeschlagen wurde.

Wie bereits erwähnt, ist ein weitgefächerter Einsatz solcher Schwingkreise tragenden Etiketten nur dann möglich, wenn diese bei höchster Präzision auch gleichzeitig preisgünstig herstellbar sind.

Die erforderliche automatische Massenfertigung dieser Produkte ist bisher insbesondere bezüglich den Präzisionsanforderungen auf grosse Hindernisse gestossen.

Zweck der vorliegenden Erfindung ist die Schaffung eines neuartigen Herstellungsverfahrens, welches unter Einsatz herkömmlicher Ausgangsmaterialien die wirtschaftliche Massenfertigung von Schwingkreise der genannten Art tragenden Etiketten erlaubt, ohne dabei einen Präzisionsverlust in Kauf nehmen zu müssen.

Das Verfahren zeichnet sich zu diesem Zweck erfindungsgemäss dadurch aus, dass
- auf die eine Seite eines Streifens aus elektrisch leitendem Material ein Heisssiegelkleber aufgebracht und aus einem mittleren Abschnitt des mit dem Kleber versehenen Streifens der darin zu liegen kommende Teil der Schaltung mit der einen Fläche des kapazitiven Elementes jeder Etikette herausgearbeitet wird,
- dass daraufhin auf die mit dem Kleber versehene Seite dieses bearbeiteten Mittelabschnittes kontinuierlich ein Band aus elektrisch isolierendem Material aufgebracht und mit den elektrisch leitenden Teilen des Mittelabschnittes des leitenden Streifens verklebt wird,
- dass anschliessend die in die Aussenabschnitte des leitenden Streifens zu liegen kommenden Teile der Schaltung jeder Etikette herausgearbeitet werden,
- dass zudem nach dem Herausarbeiten des im mittleren Abschnitt liegenden Schaltungsteils, spätestens aber nach dem Herausarbeiten der äusseren Schaltungsteile der ganze Streifen auf der dem isolierenden Materialband abgewandten Seite mit einer Abdeckfolie bedeckt und mit dieser verbunden wird, und
- dass schliesslich auf das isolierende Materialband die rückseitigen Schaltungsteile, insbesondere die Gegenfläche des kapazitiven Elementes aus elektrisch leitendem Material für jede Etikette aufgebracht und mit den Schaltungsteilen der Vorderseite elektrisch verbunden werden.

Vorzugsweise werden dabei die rückseitigen Schaltungsteile suksessive aus einem weiteren Streifen aus elektrisch leitendem Material, beispielsweise aus einem Aluminiumband, herausgearbeitet und mustergemäss auf das isolierende Materialband aufgebracht.

Bei einer besonders bevorzugten Ausführungsform des Verfahrens werden auf demselben leitenden Materialstreifen gleichzeitig zwei parallel verlaufende Etikettenreihen hergestellt, wobei die beiden Reihen vorzugsweise spiegelbildlich angeordnet sind und der mittlere Streifenabschnitt mit Schaltungsteilen der nebeneinander liegenden Etiketten versehen wird, während die Aussenabschnitte des Streifens mit den die Schaltungen jeder Etikette ergänzenden Schaltungsteilen versehen werden.

Als leitender Materialstreifen wird vorzugsweise ein Aluminiumband von zum Beispiel 50 µm Dicke verwendet. Das isolierende Materialband besteht vorzugsweise aus einem Polypropylenband, welches mit einem Haftförderer, z.B. PVDC beschichtet sein kann.

Als Abdeckfolie wird üblicherweise ein isolierendes Deckpapier verwendet.

Vorzugsweise werden die verschiedenen Schaltungsteile durch Stanzen aus den leitenden Materialbändern herausgearbeitet.

Die auf vorstehend beschriebene Weise hergestellten Etiketten werden vorzugsweise anschliessend noch auf die Frequenzgenauigkeit der einzelnen Schwingkreise hin überprüft, wobei die elektrischen Ist-Werte festgestellt und mit den Soll-Werten verglichen werden und bei unzulässigen Abweichungen von den Soll-Werten entweder die erforderlichen Korrekturen durch Nacharbeiten der bestehenden Schaltungsteile, insbesondere der rückseitigen Kondensatorfläche, vorgenommen oder die entsprechenden Etiketten ausgeschieden werden.

Die Erfindung wird nachstehend anhand von in der Zeichnung dargestellten Ausführungsbeispielen noch etwas näher erläutert. Es zeigt:
Fig. 1 - 3 eine rein schematisch dargestellte Anlage, auf welcher die verschiedenen sich folgenden Schritte des Herstellungsverfahrens ausgeführt werden können;
Fig. 4 verschiedene Querschnitte, in vergrössertem Massstab, an den angezeigten Schnittstellen durch einen Etikettenstreifen, wobei die verschiedenen Materialschichten an den gezeigten Stellen dargestellt sind;
Fig. 5 eine rein schematisch dargestellte Stanzvorrichtung, wie eine solche an verschiedenen Stationen der Anlage zur Durchführung des Verfahrens eigesetzt werden kann;
Fig. 6 und 7 schliesslich rein schematisch einen Ausschnitt aus einem Etikettenstreifen nach den zwei wichtigsten Stanzvorgängen.

Nach dem nachstehend beschriebenen Ausführungsbeispiel eines erfindungsgemässen Verfahrens sollen die Etiketten, welche die jeweiligen Schwingkreise tragen, auf dem Stanzweg hergestellt werden. Als Grundmaterial für die elektrisch leitenden Bestandteile der Etikette wird Aluminium verwendet. Es sei erwähnt, dass obwohl Kupfer die bessere elektrische Leitfähigkeit besitzt, aus Kostengründen Aluminium bevorzugt wird. Das ca. dreimal so hohe spezifische Gewicht von Kupfer würde die Etikette entsprechend verteuern, obwohl der Kilopreis für das Kupfer nur um weniges teurer ist als jener für Aluminium. Die Leitfähigkeit für Kupfer, die etwa 30% besser ist als bei Aluminium, würde zwar eine Materialeinsparung erlauben, jedoch ist diese nicht ausreichend um die Gesamtkosten auszugleichen. Bei Bedarf, beispielsweise für Spezialzwecke, könnte jedoch sehr wohl Kupfer anstelle von Aluminium verwendet werden, wobei der entsprechend höhere Rohstoffpreis über den Verkaufspreis aufzufangen wäre.

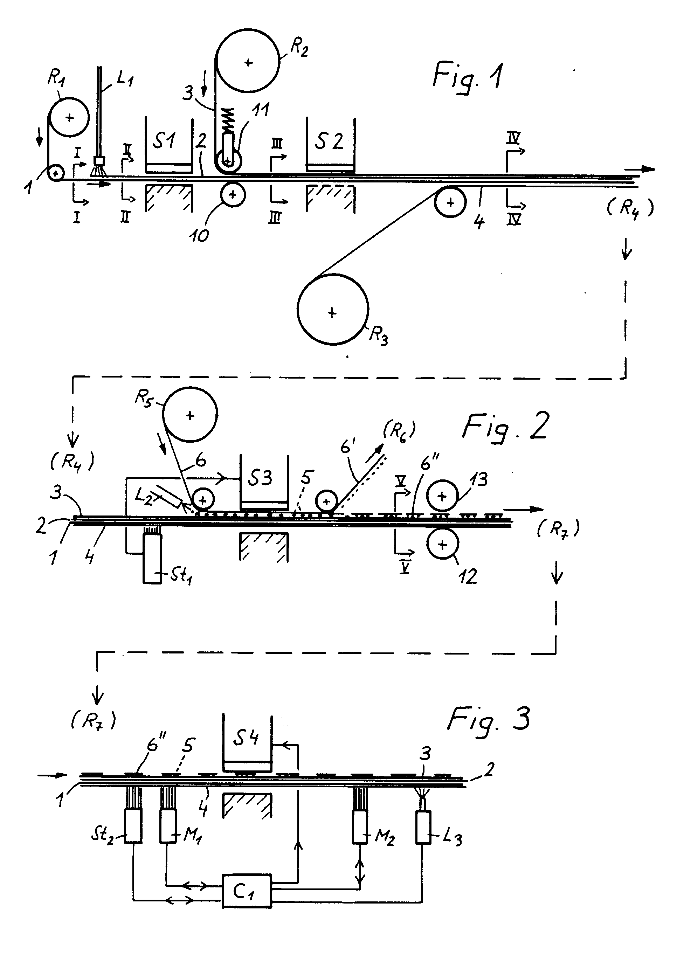

Anhand der in den Fig. 1 und 2 schematisch dargestellten Anlage wird nachstehend der Ablauf des Herstellungsverfahrens näher erläutert. Ab einer Rolle R₁ wird ein Aluminiumband 1 abgerollt und mittels einer Vorrichtung L₁ mit einer Schicht eines Heisssiegelklebers 2 versehen.

Das Aluminiumband 1 weist beispielsweise eine Dicke von 50 µm auf. Der auf die eine Seite des Bandes 1 aufgebrachte Heissiegelkleber, z.B. Heissiegellack ist ein Klebstoff, der vor der Verklebung abtrocknet und dann mit der Gegenseite erst durch Anwendung starken Druckes unter gleichzeitiger kurzer Hitzeeinwirkung verklebt wird.

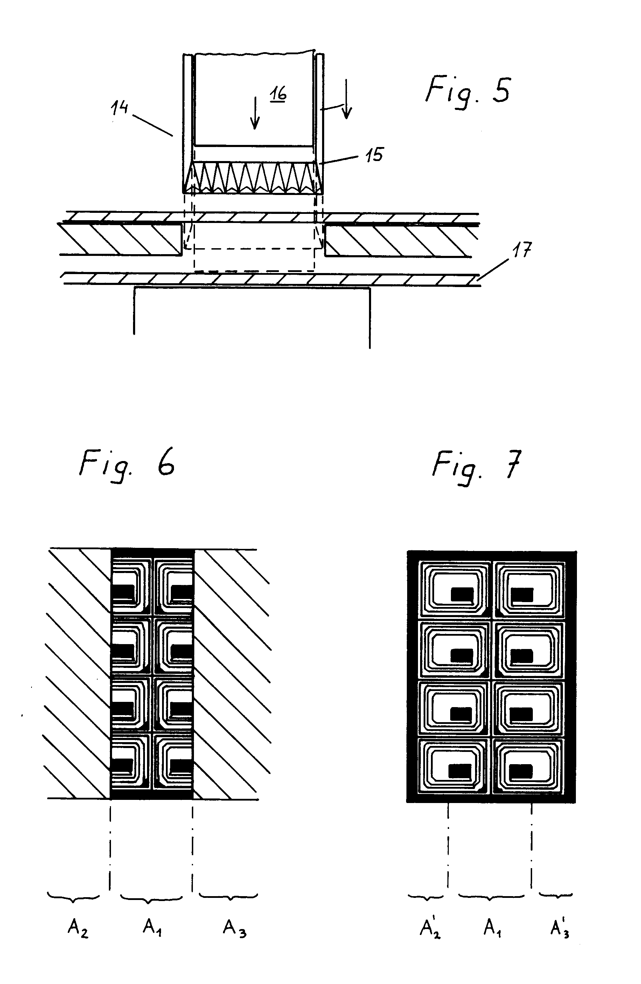

Das einseitig mit dem Heissiegelkleber 2 beschichtete Aluminiumband 1 wird dann durch eine erste Stanzvorrichtung S₁ geführt, in welcher im mittleren Bandabschnitt A₁ (siehe Fig. 6) ein erster Teil der induktiven Elemente, d.h. der Spulen von hintereinander angeordneten Etiketten ausgestanzt wird. Beim gezeigten Beispiel (Fig. 6) werden auf demselben Aluminiumband 1 gleichzeitig zwei parallel verlaufende Etikettenreihen hergestellt. Die beiden Reihen sind dabei spiegelbildlich angeordnet, so dass der mittlere Streifenabschnitt A₁ mit Schaltungsteilen der nebeneinander liegenden Etiketten versehen werden können, und zwar in einem Stanzvorgang. In der Zeichnung, insbesondere Fig. 6 und 7, zeigen die hellen Stellen die aus dem Aluminiumband 1 herausgestanzten Teile, während die dunkeln Stellen aus Aluminium bestehen, welche alle mit dem Grundstreifen zusammenhängen.

Anschliessend an den Stanzvorgang in der Stanzvorrichtung S₁ fährt das Aluminiumband 1, welches mit Heissiegelkleber 2 beschichtet ist, zwischen zwei Kalibrierwalzen 10, 11 hindurch, wobei gleichzeitig über die obere Kalibrierwalze 11 ein aus isolierendem Material bestehendes Band 3 zugeführt wird, welches auf den mittleren Abschnitt A₁ auf der mit Heissiegelkleber 2 beschichteten Seite des Aluminiumbandes 1 aufgelegt und mit den dort bereits ausgestanzten Leiterbahnen verklebt wird. Die Verklebung erfolgt zwischen den Walzen 10 und 11, welche zur Aktivierung des Klebers noch zusätzlich beheizt sein können. Durch das Aufbringen des isolierenden Materialbandes auf die im Abschnitt A₁ liegenden Spulenteile wird die Formstabilität der ausgestanzten Teile gewährleistet. Die Formstabilität der Spulenteile der einzelnen Etiketten bis zum Aufbringen des nichtleitenden Bandes 3 ist dadurch gewährleistet, dass nur ein kleiner Teil der Spulen vorgestanzt wurde, welche zu einem Teil erst noch direkt mit den äusseren Abschnitten A₂ und A₃ des Aluminiumbandes 1 zusammenhängen.

Das Band 3 aus nichtleitendem Material, welches gleichzeitig als Dielektrikum für den noch zu bildenden Kondensator einerseits und als Stabilisator für die ausgestanzten Spulen dienen soll, besteht vorzugsweise aus einer Kunststoffolie mit bestimmten elektrischen Eigenschaften im entsprechenden Frequenzbereich, beispielsweise einer Polypropylenfolie. Diese Folie ist zwar teurer als eine solche aus Polyäthylen, hat aber eine wesentlich höhere Zugfestigkeit und damit Formstabilität sowie bessere elektrische Werte. Diese Eigenschaften erlauben den Einsatz einer verhältnismässig dünnen Folie, zum Beispiel 9 bis 15µm, was sowohl wiederum die Kosten reduziert aber vor allem zu kleineren Kondensatoren führen kann (das grössere verbleibende "Loch" im Innern der Spule erlaubt eine bessere Detektion). Zudem wird die Spule formstabiler, was zu einer engeren Frequenztoleranz führt.

Das Aufbringen des Heissiegelklebers erlaubt nicht nur das Festkleben der Kunststoffolie bzw. des Bandes 3, sondern verhindert auch ein sogenanntes Aufbauschneiden beim Stanzvorgang, da damit eine Art Schmierung für das Stanzwerkzeug erfolgt.

Das im mittleren Abschnitt A₁ ausgestanzte und mittels des isolierenden Bandes 3 stabilisierte Aluminiumband 2 wird anschliessend durch eine zweite Stanzvorrichtung S₂ geführt, wo nun die in den äusseren Abschnitten A₂ und A₃ zu liegen kommenden Teile der elektrischen Schaltung ausgestanzt werden. Da der mittlere Abschnitt A₁ durch die aufgeklebte Kunststofffolie 3 stabilisiert ist, bleiben nun auch die in den äusseren Abschnitten A₂ und A₃ liegenden Teile stabil genug.

Anschliessend an diesen zweiten Stanzvorgang wird auf die Unterseite des Aluminiumbandes 1 eine Deckfolie aus isolierendem Material, beispielsweise aus Deckpapier 4 aufgebracht, bzw. aufkaschiert und mit dem Aluminiumband 1 verklebt. Damit sind nun die teilweise fertiggestellten Etiketten für den weiteren Verfahrensablauf vollständig stabilisiert.

An dieser Stelle besteht nun der Etikettenstreifen aus einer zu unterst liegenden Deckpapierschicht 4, darüber dem Aluminiumband 1, anschliessend der Heisskleberschicht 2 und darüber aus der isolierenden Kunststoffolie 3.

Wie Fig. 2 zeigt, wird nun dieser Streifen einer weiteren Station zugeführt, in welcher zu jeder Etikette der zweite Teil des Kondensators aufgebracht und elektrisch mit der auf der andern Seite des isolierenden Materials liegenden Spule verbunden wird. Dazu wird gegebenenfalls mittels dem Gerät L₂ ein weiterer Kleber auf die Oberseite des isolierenden Materialstreifens 3 aufgebracht und aus einem weiteren Aluminiumstreifen 6, welcher von einer Rolle R₅ abgerollt wird, in einer weiteren Stanzvorrichtung S₃ die rückseitige Fläche des Kondensators und gegebenenfalls damit verbundene Leiterbahnen ausgestanzt und auf dem Band aus isolierendem Material 3 mustergemäss angebracht. Die nicht verwendeten Teile des Aluminiumbandes 6 werden in Form des Bandes 6′ abgeführt.

Selbstverständlich sorgen geeignete Steuereinrichtungen St₁ für die richtige Steuerung der Stanzvorrichtung S₃ und die richtige Positionierung der anderen Kondensatorfläche auf dem isolierenden Band 3, d.h. für das flächendeckende Anbringen dieser rückseitigen Kondensatorteile über der Kondensatorfläche im bereits früher hergestellten Schaltungsteil.

Zum Aufkleben der rückseitigen Schaltungsteile wird wie bereits erwähnt, ein weiterer Kleber eingesetzt, welcher selbstverständlich statt auf die nichtleitende Folie auch auf die Unterseite des Aluminiumbandes 6 aufgebracht werden kann. Es kann hierfür ebenfalls ein Heissiegelkleber verwendet werden. Da aber die eingesetzten präzisen Stanzwerkzeuge nur schwierig beheizbar sind, kann der zweite Flächenteil des Kondensators und die zugehörigen Schaltungsteile vorerst auf der nichtleitenden Folie 3 provisorisch angeheftet werden, was beispielsweise mittels Ultraschallsonden erfolgen kann. Die eigentliche Versiegelung dieser rückseitigen Schaltungsteile mit der nichtleitenden Folie 3 kann dann später zwischen zwei beheizten Kaschierwalzen 12 und 13 erfolgen.

Nun ist an und für sich der Etikettenstreifen fertig gestellt. Die einzelnen Etiketten können gegebenenfalls voneinander getrennt oder in Form von grösseren Streifen verpackt werden.

Vorzugsweise werden aber die mit den Schwingkreisen versehenen Etiketten noch auf Frequenzgenauigkeit überprüft. Ein Prozessrechner vergleicht damit die Soll-Frequenz mit der Ist-Frequenz, wobei je nach vorgegebenen Toleranzwerten und abweichenden Ist-Werten eine weitere Stanzvorrichtung S₄ (Fig. 3) angesteuert wird, welche die Fläche des Kondensators entsprechend verkleinert. Hierzu wird nur der rückseitige Kondensatorteil angestanzt, um den Kondensator zu verkleinern.

Fig. 3 der Zeichnung zeigt rein schematisch wie die Etikettenstreifen mittels der Vorrichtungen St₂ und M₁ zur Frequenzmessung angesteuert werden, wobei der Vergleich über den Rechner C₁ erfolgt, und gegebenenfalls die Stanzvorrichtung S₄ zur Kondensatorabgleichung entsprechende Steuerbefehle erhält. Eine Nachmessung kann durch das Gerät M₂ erfolgen, wonach schlechte Etiketten beispielsweise mittels der Vorrichtung L₃ gekennzeichnet werden.

Selbstverständlich sind auch andere Korrekturmethoden denkbar.

Die so fertiggestellten und geprüften Etiketten werden dann verpackt und dem Endzweck zugeführt.

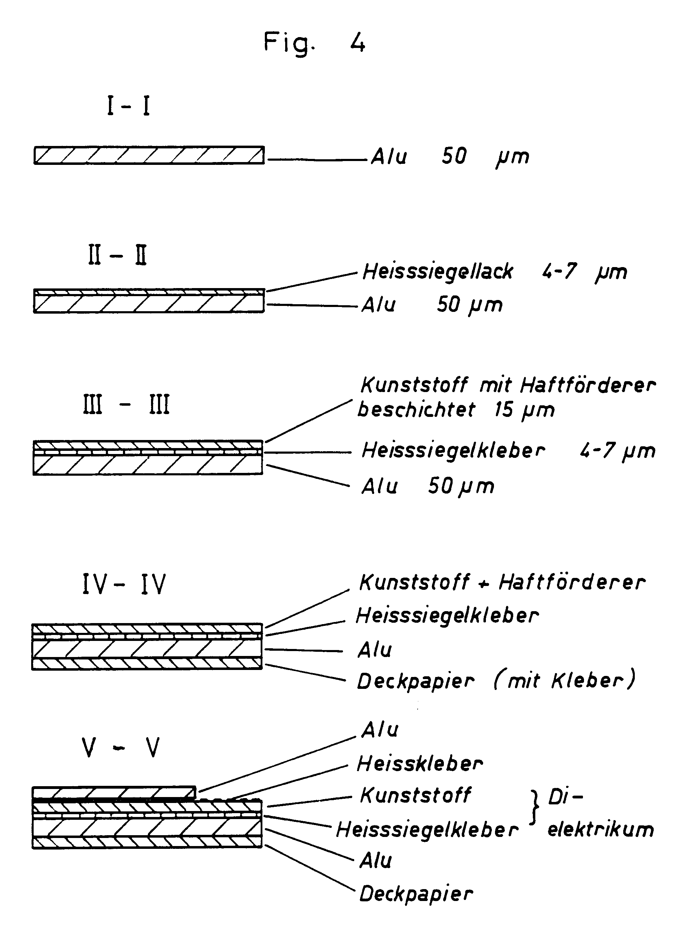

Fig. 4 der Zeichnung zeigt rein schematich und in vergrössertem Massstab an den angezeigten Schnittstellen der Figuren 1 bis 3 den Aufbau der verschiedenen Schichten des Etikettstreifens.

Fig. 5 der Zeichnung zeigt schliesslich eine rein schematische Ausführungsform einer Stanzvorrichtung, wobei mittels der eigentlichen Stanzwerkzeuge 15 die Ausstanzungen vorgenommen werden, während mittels dem Stössel 16 entweder die entfernten Teile weggestossen oder die ausgestanzten Teile (z.B. Stanzvorrichtung S₃) auf den darunter liegenden Bandstreifen 17 aufgedrückt werden.

## Patentansprüche

1. Verfahren zur Herstellung einer Vielzahl von auf einem Streifen hintereinander angeordneten Etiquetten, von denen jede jeweils eine einen Schwingkreis bildende Schaltung aus einem induktiven und wenigstens einem kapazitiven Element trägt und einen isolierenden Träger umfasst, auf dessen einer Seite das aus flachen elektrischen Leiterbahnen gebildete induktive Element und mit letzterem verbunden die eine Fläche des kapazitiven Elementes mustergemäss angeordnet sind, während sich auf der Rückseite des isolierenden Trägers die Gegenfläche des kapazitiven Elementes, mit dem Schaltkreis auf der Vorderseite elektrisch verbunden, befindet, dadurch gekennzeichnet, dass
- auf die eine Seite eines Streifens aus elektrisch leitendem Material ein Heisssiegelkleber aufgebracht und aus einem mittleren Abschnitt des mit dem Kleber versehenen Streifens der darin zu liegen kommende Teil der Schaltung mit der einen Fläche des kapazitiven Elementes jeder Etikette herausgearbeitet wird,
- dass daraufhin auf die mit dem Kleber versehene Seite dieses bearbeiteten Mittelabschnittes kontinuierlich ein Band aus elektrisch isolierendem Material aufgebracht und mit den elektrisch leitenden Teilen des Mittelabschnittes des leitenden Streifens verklebt wird,
- dass anschliessend die in die Aussenabschnitte des leitenden Streifens zu liegen kommenden Teile der Schaltung jeder Etikette herausgearbeitet werden,
- dass zudem nach dem Herausarbeiten des im mittleren Abschnitt liegenden Schaltungsteils, spätestens aber nach dem Herausarbeiten der äusseren Schaltungsteile der ganze Streifen auf der dem isolierenden Materialband abgewandten Seite mit einer Abdeckfolie bedeckt und mit dieser verbunden wird, und
- dass schliesslich auf das isolierende Materialband die rückseitigen Schaltungsteile, insbesondere die Gegenfläche des kapazitiven Elementes aus elektrisch leitendem Material für jede Etikette aufgebracht und mit den Schaltungsteilen der Vorderseite elektrisch verbunden werden.

2. Verfahren nach Anspruch 1, dadurch gekennzeichnet, dass die rückseitigen Schaltungsteile sukzessive aus einem weiteren Streifen aus elektrisch leitendem Material, beispielsweise aus einem Aluminiumband, herausgearbeitet, beispielsweise herausgestanzt und mustergemäss auf das isolierende Materialband aufgebracht werden.

3. Verfahren nach Anspruch 1 oder 2, dadurch gekennzeichnet, dass auf demselben leitenden Materialstreifen gleichzeitig zwei parallel verlaufende Etikettenreihen hergestellt werden, wobei die beiden Reihen vorzugsweise spiegelbildlich angeordnet sind, und der mittlere Streifenabschnitt mit Schaltungsteilen der nebeneinander liegenden Etiketten versehen wird, während die Aussenabschnitte des Streifens mit den die Schaltungen jeder Etikette ergänzenden Schaltungsteilen versehen werden.

4. Verfahren nach einem der Ansprüche 1-3, dadurch gekennzeichnet, dass als leitender Materialstreifen ein Aluminiumband von beispielsweise 50 µm Dicke verwendet wird.

5. Verfahren nach einem der Ansprüche 1-4, dadurch gekennzeichnet, dass als isolierendes Materialband ein Polypropylen-, Polystyrol- oder Polyäthylenband, vorzugsweise ein mit einem Haftförderer, z.B. mit PVDC beschichtetes Polypropylenband von z.B. 9-15 µm Dicke verwendet wird.

6. Verfahren nach einem der Ansprüche 1-5, dadurch gekennzeichnet, dass als Abdeckfolie ein isolierendes Deckpapier verwendet wird.

7. Verfahren nach einem der Ansprüche 1-6, dadurch gekennzeichnet, dass als leitendes Material für die rückseitigen Schaltungsteile ebenfalls ein Aluminiumband verwendet wird.

8. Verfahren nach einem der Ansprüche 1-7, dadurch gekennzeichnet, dass die verschiedenen Schaltungsteile durch Stanzen aus den leitenden Materialien herausgearbeitet werden.

9. Verfahren nach einem der Ansprüche 1-8, dadurch gekennzeichnet, dass anschliessend noch eine Ueberprüfung der Frequenzgenauigkeit der einzelnen Schwingkreise erfogt, wobei die elektrischen Ist-Werte festgestellt und mit den Soll-Werten verglichen werden und bei unzulässigen Abweichungen von den Soll-Werten entweder die erforderlichen Korrekturen durch Nacharbeiten der bestehenden Schaltungsteile, insbesondere der rückseitigen Kondensatorfläche, vorgenommen oder die entsprechenden Etiketten ausgeschieden werden.

10. Verfahren nach Anspruch 9, dadurch gekennzeichnet, dass die gegebenenfalls notwendigen Korrekturarbeiten mittles Stanzen, Laser oder durch Aetzen erfolgen.

## Claims

1. Method for the production of a plurality of tags successively arranged on a strip and whereof each carries a circuit forming a resonant circuit of an inductive element and at least one capacitive element and comprises an insulating support, on whose one side are located the inductive element formed from flat, electrical conducting tracks and connected to the latter one surface of the capacitive element in pattern-like manner, whilst on the back of the insulating support is located the opposite surface of the capacitive element electrically connected to the circuit on the front, characterized in that on one side of a strip of electrically conductive material is applied a hot-sealing adhesive and from a central portion of the strip provided with the adhesive the part of the circuit to be located there is formed with one surface of the capacitive element of each tag, that then to the side of this worked central portion provided with the adhesive is continuously applied a band of electrically insulating material and is bonded to the electrically conductive parts of the central portion of the conductive strip, that subsequently the parts of the circuit of each tag to be located in the outer portions of the conductive strip are formed, that following the formation of the circuit part located in the central portion and at the latest after forming the outer circuit part the entire strip is covered on the side remote from the insulating material band with a cover film and is connected thereto and that finally on the insulating material band is applied the back circuit parts, particularly the opposite face of the capacitive element of electrically conductive material for each tag and are electrically connected to the circuit parts of the front.

2. Method according to claim 1, characterized in that the back circuit parts are successively formed from a further strip of electrically conductive material, e.g. from an aluminium band and for instance by punching and are applied in pattern-like manner to the insulating material band.

3. Method according to claims 1 or 2, characterized in that on the same conductive material strip are simultaneously produced two parallel tag rows, the two rows being preferably homologously arranged and the central strip portion is provided with circuit parts of the juxtaposed tags, whilst the outer portions of the strip are provided with circuit parts supplementing the circuits of each tag.

4. Method according to one of the claims 1 to 3, characterized in that an e.g. 50 µm thick aluminium band is used as the conductive material strip.

5. Method according to one of the claims 1 to 4, characterized in that the insulating material band is constituted by a polypropylene, polystyrene or polyethylene band, preferably an e.g. 9 to 15 µm thick polypropylene band coated with an adhesion promoter, e.g. with PVDC.

6. Method according to one of the claims 1 to 5, characterized in that an insulating covering paper is used as the cover film.

7. Method according to one of the claims 1 to 6, characterized in that an aluminium band is also used as the conductive material for the back circuit parts.

8. Method according to one of the claims 1 to 7, characterized in that the different circuit parts are produced by punching from the conductive materials.

9. Method according to one of the claims 1 to 8, characterized in that subsequently the frequency precision of the individual resonant circuits is checked, the electrical actual values being determined and compared with the nominal values and in the case of inadmissible divergences from the nominal values either the necessary corrections are made by reworking the existing circuit parts, particularly the back capacitor surface, or the corresponding tags are eliminated.

10. Method according to claim 9, characterized in that the optionally necessary correction work takes place by punching, lasers or by etching.

## Revendications

1. Procédé pour fabriquer une multiplicité d'étiquettes, qui sont disposées les unes derrière les autres sur une bande et dont chacune porte respectivement un circuit constituant un circuit oscillant et formé par un élément inductif et au moins un élément capacitif, et comporte un support isolant, sur une face duquel sont disposés, selon une configuration, l'élément inductif formé de voies conductrices électriques plates et une première surface, raccordée à cet élément, de l'élément capacitif, tandis que sur la face arrière du support isolant est disposée la surface opposée de l'élément capacitif, qui est raccordée électriquement au circuit situé sur la face avant, caractérisé en ce que
- on dépose une colle de thermoscellement sur une face d'une bande formée d'un matériau électriquement conducteur et on dégage à partir d'une section médiane de la bande équipée de la colle, la partie, qui vient s'appliquer dans cette section, du circuit comportant la première surface de l'élément capacitif de chaque étiquette,
- qu'ensuite on dépose en continu une bande formée d'un matériau électriquement isolant sur la face, recouverte par la colle, de cette section médiane traitée et qu'on la colle sur les parties électriquement conductrices de la section médiane de la bande conductrice,
- qu'ensuite on dégage les parties, qui viennent s'appliquer dans les sections extérieures de la bande conductrice, du circuit de chaque étiquette,
- qu'en outre, après avoir dégagé la partie du circuit située dans la section médiane, mais tout au plus après avoir dégagé les parties extérieures du circuit, on recouvre l'ensemble de la bande, sur sa face tournée à l'opposé de la bande en matériau isolant, par une feuille de revêtement et qu'on la raccorde à cette feuille, et
- qu'enfin, on dépose sur la bande de matériau isolant, les parties du circuit situées sur la face arrière, notamment la surface opposée de l'élément capacitif formé d'un matériau électriquement conducteur pour chaque étiquette et qu'on raccorde ladite bande électriquement aux éléments du circuit, qui sont présents sur la face avant.

2. Procédé selon la revendication 1, caractérisé en ce qu'on dégage, par exemple par découpage, successivement les éléments du circuit, situés sur la face arrière, à partir d'une autre bande formée d'un matériau électriquement conducteur, par exemple d'une bande d'aluminium, et qu'on les dépose, conformément à une configuration, sur la bande de matériau isolant.

3. Procédé selon la revendication 1 ou 2, caractérisé en ce qu'on fabrique simultanément deux rangées parallèles d'étiquettes sur la même bande de matériau conducteur, les deux rangées étant disposées de préférence selon une disposition symétrique, et qu'on équipe la section médiane de la bande d'éléments de circuit des étiquettes disposées côte-à-côte, tout en équipant les sections extérieures de la bande des éléments de circuit complétant les circuits de chaque étiquette.

4. Procédé selon l'une des revendications 1-3, caractérisé en ce qu'on utilise, comme bande de matériau conducteur, une bande d'aluminium possédant une épaisseur égale par exemple à 50 µm.

5. Procédé selon l'une des revendications 1-4, caractérisé en ce qu'on utilise, comme bande de matériau isolant, une bande de polypropylène, de polystyrène ou de polyéthylène, de préférence une bande de polypropylène recouverte d'un agent favorisant l'adhérence, par exemple du PVDC, et possédant par exemple une épaisseur de 9-15 µm.

6. Procédé selon l'une des revendications 1-5, caractérisé en ce qu'on utilise comme feuille de revêtement un papier de revêtement isolant.

7. Procédé selon l'une des revendications 1-6, caractérisé en ce qu on utilise également une bande d'aluminium comme matériau conducteur pour les éléments de circuit situés sur la face arrière.

8. Procédé selon l'une des revendications 1-7, caractérisé en ce que les différents éléments de circuit sont dégagés par découpage à partir des matériaux conducteurs.

9. Procédé selon l'une des revendications 1-8, caractérisé en ce qu'ensuite on exécute encore un contrôle de la précision de la fréquence des circuits oscillants individuels, en déterminant les valeurs réelles électriques et en les comparant à des valeurs de consigne et, dans le cas d'écarts inadmissibles par rapport aux valeurs de consigne, soit en exécutant les corrections nécessaires par usinage complémentaire des éléments des circuits existants, notamment de la surface du condensateur, située sur la face arrière, soit en jetant les étiquettes correspondantes.

10. Procédé selon la revendication 9, caractérisé en ce que les travaux de correction éventuellement nécessaires sont réalisés au moyen d'un découpage, par laser ou par corrosion.
